(19) Europäisches Patentamt
European Patent Office
Office européen des brevets

(11) **EP 2 720 055 A2**

(12) **EUROPEAN PATENT APPLICATION**

(43) Date of publication:
16.04.2014 Bulletin 2014/16

(51) Int Cl.:
*G01R 31/36* (2006.01)

(21) Application number: 13186266.6

(22) Date of filing: 27.09.2013

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **10.10.2012 JP 2012224844**

(71) Applicant: **GS Yuasa International Ltd.**
**Kisshoin**
**Minami-ku, Kyoto-shi**
**Kyoto 601-8520 (JP)**

(72) Inventors:
• **Sekiguchi, Hiroshi**
**Kyoto, 601-8520 (JP)**
• **Nakamura, Masashi**
**Kyoto, 601-8520 (JP)**

(74) Representative: **Grünecker, Kinkeldey,**
**Stockmair & Schwanhäusser**
**Leopoldstrasse 4**
**80802 München (DE)**

(54) **Device and method for estimating chargeable/dischargeable power of electric storage device**

(57) A CPU (12) calculates a first correction factor ($\alpha$) and a chargeable power value WC1 if a condition of a secondary battery (5) is a current limit condition. The CPU (12) calculates a second correction factor ($\beta$) if the condition of the secondary battery (5) is a voltage limit condition and calculates a chargeable power value WC2 if a present SOC of the secondary battery (5) is higher than a borderline SOC. The CPU (12) calculates an assumed chargeable power value WCK if the current SOC of the secondary battery (5) is equal to or lower than the borderline SOC and calculates a chargeable power value WC2.

FIG.1

EP 2 720 055 A2

## Description

FIELD

Technologies described herein relates to a technology for estimating chargeable/dischargeable power of an electric storage device.

BACKGROUND

Chargeable/dischargeable power is the maximum power that can be input to or output from an electric storage device. For example, in some hybrid vehicles, a monitoring unit for monitoring a secondary battery estimates a chargeable/dischargeable power of the secondary battery and a hybrid control ECU calculates a target power of an engine based on the chargeable/dischargeable power. Conventionally, there is a control unit including a plurality of tables containing chargeable/dischargeable power data corresponding to charge conditions (or states of charge, or remaining capacities, hereinafter referred to as SOCs) of a secondary battery and being configured to estimate chargeable/dischargeable power (JP-A-2007-151216).

A relationship between SOC and chargeable/dischargeable power may vary according to deterioration of a secondary battery, which is not sufficiently considered in the above known technology. Therefore, the control unit cannot accurately estimate the chargeable/dischargeable power and thus cannot make the maximum use of the charging/dischargeable performance of the secondary battery.

SUMMARY

This specification describes a technology for reducing inaccurate estimation of chargeable/dischargeable power due to deterioration of an electric storage device.

A power estimation device described in this specification is for estimating at least one of chargeable power and dischargeable power of an electric storage device. The power estimation device includes a memory unit and a processing unit. The memory unit is configured to store a reference power value. The processing unit is configured to perform: a condition determination process to determine whether a condition of the electric storage device is a voltage limit condition or a current limit condition; a first power estimation process to estimate at least one of chargeable power and dischargeable power of the electric storage device by multiplying the reference power value by a first correction factor if the condition of the electric storage device is the current limit condition; and a second power estimation process to estimate chargeable/dischargeable power by multiplying the reference power value by a second correction factor that is different from the first correction factor if the condition of the electric storage device is the voltage limit condition.

BRIEF DESCRIPTION OF DRAWINGS

FIG. 1 is a block diagram illustrating a configuration of a battery pack according to an embodiment.
FIG. 2 is a graph illustrating relationships among an open circuit voltage, an upper limit voltage, an upper limit current, and an internal resistance of a secondary battery.
FIG. 3 is a graph illustrating relationships among an open circuit voltage, a lower limit voltage, a lower limit current, and an internal resistance of the secondary battery.
FIG. 4 is a flowchart of a power estimation process (during charge).
FIG. 5 is a flowchart of a chargeable power estimation process.
FIG. 6 is a graph illustrating relationships between chargeable power and SOC.
FIG. 7 is a flowchart of a range determination process during charge.
FIG. 8 is a flowchart of a power estimation process (during discharge).
FIG. 9 is a flowchart of a range determination process during discharge.
FIG. 10 is a graph illustrating relationships between dischargeable power and SOC.
FIG. 11 is a flowchart of a range determination process during discharge.

DESCRIPTION OF EMBODIMENTS

According to a first aspect, there is provided a power estimation device for estimating at least one of chargeable power and dischargeable power of an electric storage device, the power estimation device including a memory unit and a processing unit. The memory unit is configured to store a reference power value. The processing unit is configured to perform: a condition determination process to determine whether a condition of the electric storage device is a voltage limit condition or a current limit condition; a first power estimation process to estimate at least one of chargeable power and dischargeable power of the electric storage device by multiplying the reference power value by a first correction factor if the condition of the electric storage device is the current limit condition; and a second power estimation process to estimate chargeable/dischargeable power by multiplying the reference power value by a second correction factor that is different from the first correction factor if the condition of the electric storage device is the voltage limit condition.

During charge of the electric storage device, the condition of the electric storage device is either one of a voltage limit condition in which a terminal voltage reaches an upper limit voltage before a charge current reaches an upper limit current and a current limit condition in which the charge current reaches the upper limit current before the terminal voltage reaches the upper limit voltage. If an internal resistance of the electric storage device increases due to deterioration or a temperature increase, a chargeable power value tends to decrease when the condition of the electric storage device is the voltage limit condition. When the condition of the electric storage device is the current limit condition, the chargeable power value tends to increase.

During discharge of the electric storage device, the condition of the electric storage device is either one of a voltage limit condition in which a terminal voltage reaches a lower limit voltage before a discharge current reaches a lower limit current and a current limit condition in which the discharge current reaches the lower limit current before the terminal voltage reaches the lower limit voltage. If an internal resistance of the electric storage device increases due to deterioration or a temperature increase, a dischargeable power value tends to decrease when the condition of the electric storage device is the voltage limit condition. When the condition of the electric storage device is the current limit condition, the dischargeable power value also tends to decrease. However, a rate of decrease in dischargeable power of the electric storage device in the voltage limit condition defers from that of the electric storage device in the current limit condition.

In the power estimation device according to the first aspect, the processing unit estimates at least one of the chargeable power and the dischargeable power of the electric storage device by multiplying the reference power value of the chargeable/dischargeable power by the first correction factor if the condition of the electric storage device is the current limit condition. Furthermore, the processing unit estimates the chargeable/dischargeable power of the electric storage device by multiplying the reference power value by the second correction factor that is different from the first correction factor if the condition of the electric storage device is the voltage limit condition. With this configuration, the processing unit is less likely to inaccurately estimate the chargeable/dischargeable power in comparison to a configuration in which the same factor is used in any multiplication regardless of whether the condition of the electric storage device is the current limit condition or the voltage limit condition.

According to a second aspect, the memory unit is configured to store reference voltage information related to a reference voltage that is a terminal voltage of the electric storage device when an internal resistance of the electric storage device is equal to a reference resistance and a current flowing through the electric storage device is equal to a limit current that is an upper limit current or a lower limit current, and reference current information related to a reference current that is a current flowing through the electric storage device when an internal resistance of the electric storage device is equal to the reference resistance and a terminal voltage of the electric storage device is equal to a limit voltage that is an upper limit voltage or a lower limit voltage. Furthermore, the processing unit is further configured to: perform an internal resistance estimation process to estimate an internal resistance of the electric storage device; estimate a terminal voltage of the electric storage device when a current flowing through the electric storage device is equal to the limit current based on the internal resistance estimated in the internal resistance estimation process and define a value calculated by dividing the estimated terminal voltage by the reference voltage as a first correction factor in the first power estimation process; and estimate a current flowing through the electric storage device when a terminal voltage of the electric storage device is equal to the limit voltage based on the estimated internal resistance and define a value calculated by dividing the estimated current by the reference current as a second correction factor in the second power estimation process.

In the power estimation device according to the second aspect, the processing unit defines the correction factors based on the reference voltage and the reference current corresponding to the reference resistance and from the terminal voltage and the current corresponding to the estimated internal resistance. Therefore, appropriate correction factors according to variations in internal resistance can be obtained during charge/discharge.

According to a third aspect, the memory unit is configured to store reference voltage information and the reference current information including values corresponding to a reference open circuit voltage that is an open circuit voltage of the electric storage device when the internal resistance of the electric storage device is equal to the reference resistance. The reference power value is a chargeable/dischargeable power value when the open circuit voltage of the electric storage device is equal to the reference open circuit voltage. The processing unit is further configured to: perform an open circuit voltage estimation process to estimate an open circuit voltage of the electric storage device; define a value calculated by dividing the estimated terminal voltage corresponding to the estimated open circuit voltage by the reference voltage as a first correction factor in the first power estimation process; and define a value calculated by dividing the estimated current corresponding to the estimated open circuit voltage by the reference current as a second correction factor in the second estimation process.

In the power estimation device according to the third aspect, the reference voltage information and the reference current information include the values corresponding to the reference open circuit voltage that is an open circuit voltage of the electric storage device when the internal resistance thereof is equal to the reference resistance, and the reference power value is a chargeable/dischargeable power value when the open circuit voltage of the electric storage device is equal to the reference open circuit voltage. Furthermore, in the power estimation device, the value calculated by dividing the estimated terminal voltage corresponding to the estimated open circuit voltage by the reference voltage is defined as the first correction factor, and the value calculated by diving the estimated current corresponding to the open circuit voltage by the reference current is defined as the second correction factor. With this configuration, if at least one chargeable power value in a specific charge condition or dischargeable power value in a specific discharge condition is stored in the memory unit as a reference power value, the first correction factor and the second correction factor for other charge condition or discharge condition can be obtained.

According to a fourth aspect, the memory unit is configured to store reference voltage information and reference current information. The reference voltage information includes a value corresponding to a reference voltage that is a terminal voltage of the electric storage device when an internal resistance of the electric storage device is equal to a reference resistance and a current flowing through the electric storage device is equal to a limit current that is an upper limit current or a lower limit current, and to a reference open circuit voltage that is an open circuit voltage of the electric storage device when the internal resistance of the electric storage device is equal to the reference resistance. The reference current information includes a value corresponding to a reference current that is a current flowing through the electric storage device when an internal resistance of the electric storage device is equal to the reference resistance and a terminal voltage of the electric storage device is equal to a limit voltage that is an upper limit voltage or a lower limit voltage, and to the reference open circuit voltage. The reference power value is a chargeable/dischargeable power value when the open circuit voltage of the electric storage device is equal to the reference open circuit voltage. The processing unit is configured to: perform an open circuit voltage estimation process to estimate an open circuit voltage of the electric storage device; perform an internal resistance estimation process to estimate an internal resistance of the electric storage device; estimate a terminal voltage of the electric storage device when a current flowing through the electric storage device is equal to the limit current based on the internal resistance estimated in the internal resistance estimation process and define a value calculated by dividing the estimated terminal voltage by the reference voltage as a first correction factor in the first power estimation process; and estimate a current flowing through the electric storage device when a terminal voltage of the electric storage device is equal to the limit voltage based on the estimated internal resistance and define a value calculated by dividing the estimated current by the reference current as a second correction factor in the second power estimation process.

In the power estimation device according to the fourth aspect, The reference voltage information includes the value corresponding to the reference voltage that is a terminal voltage of the electric storage device when the internal resistance of the electric storage device is equal to the reference resistance and the current flowing through the electric storage device is equal to the limit current that is the upper limit current or the lower limit current, and to the reference open circuit voltage that is an open circuit voltage of the electric storage device when the internal resistance of the electric storage device is equal to the reference resistance. The reference current information includes the value corresponding to the reference current that is a current flowing through the electric storage device when the internal resistance of the electric storage device is equal to the reference resistance and the terminal voltage of the electric storage device is equal to the limit voltage that is the upper limit voltage or the lower limit voltage, and to the reference open circuit voltage. Furthermore, in the power estimation device, the value calculated by dividing the estimated terminal voltage by the reference voltage as the first correction factor, and the value calculated by dividing the estimated current by the reference current as the second correction factor. With this configuration, if at least one chargeable power value in a specific charge condition or dischargeable power value in a specific discharge condition is stored in the memory unit as a reference power value, the first correction factor and the second correction factor for other charge condition or discharge condition can be obtained. Furthermore, appropriate correction factors according to variations in internal resistance can be obtained during charge/discharge.

According to a fifth aspect, the processing unit is further configured to estimate at least one of chargeable power and dischargeable power by multiplying a value larger than the reference power value by the second correction factor if the processing unit determines that the condition of the electric storage device is the voltage limit condition and a reference condition of the electric storage device corresponding to the reference power value is the current limit condition.

In the power estimation device according to the fifth aspect, the processing unit estimates at least one of the chargeable power and the dischargeable power by multiplying the value larger than the reference power value by the second correction factor if the condition of the electric storage device is the voltage limit condition and the reference condition of the electric storage device corresponding to the reference power value is the current limit condition. If the reference power value is used in chargeable/dischargeable power estimation in the voltage limit condition, a drastic change may occur in chargeable/dischargeable power. With the above configuration, such a drastic change is less likely to occur.

According to a sixth aspect, the processing unit is further configured to: estimate a variation in chargeable/dischargeable power based on a boundary condition that is a condition of the electric storage device between the current limit condition and the voltage limit condition and the reference power value in the boundary condition; estimate an assumed chargeable/dischargeable power value that is larger than the reference power value based on the variation, the boundary condition, and the reference power value in the boundary condition; and estimate at least one of the chargeable power and the dischargeable power by multiplying the assumed chargeable/dischargeable power value by the second correction factor.

In the power estimation device according to the sixth aspect, the processing unit estimates the variation in chargeable/dischargeable power and estimates the assumed chargeable/dischargeable power value based on the variation, the boundary condition that is the condition of the electric storage device between the current limit condition and the voltage limit condition, and the reference power value in the boundary condition. The assumed chargeable/dischargeable power value is larger than the reference power value. The power estimation device estimates at least one of the chargeable power and the dischargeable power by multiplying the assumed chargeable/dischargeable power value by the second correction factor. With this configuration, the chargeable/dischargeable power can be more accurately estimated in comparison to a configuration in which a value larger than the reference power value is simply multiplied by the second correction factor.

According to a seventh aspect, the processing unit is further configured to: perform a terminal voltage estimation process to estimate a terminal voltage of the electric storage device when a current flowing through the electric storage device is equal to the upper limit current or the lower limit current; and determine that the condition of the electric storage device is the voltage limit condition if the estimated terminal voltage is equal to or higher than the upper limit voltage or equal to or lower than the lower limit voltage and the condition thereof is the current limit condition if the estimated terminal voltage is lower than the upper limit voltage or higher than the lower limit voltage.

In the power estimation device according to the seventh aspect, the processing unit estimates the terminal voltage of the electric storage device when the current flowing through the electric storage device is equal to the upper limit current or the lower limit current. Furthermore, the processing unit determines that the condition of the electric storage device is the voltage limit condition if the estimated terminal voltage is equal to or higher than the upper limit voltage or equal to or lower than the lower limit voltage and determines that the condition of the electric storage device is the current limit condition if the estimated terminal voltage is lower than the upper limit voltage or higher than the lower limit voltage. With this configuration, the condition of the electric storage device can be determined through comparison of voltages, which is relatively simple method.

According to a eighth aspect, there is provided an electric storage apparatus including an electric storage device and the power estimation device.

Technologies disclosed in this specification can be applied to failure diagnosis devices, failure diagnosis methods, computer programs to implement the devices and methods, storage media storing such computer programs, and other embodiments.

According to the invention disclosed in this specification, inaccurate estimation of chargeable/dischargeable power due to deterioration of an electric storage device is less likely to occur.

Electric Configuration of Battery Pack

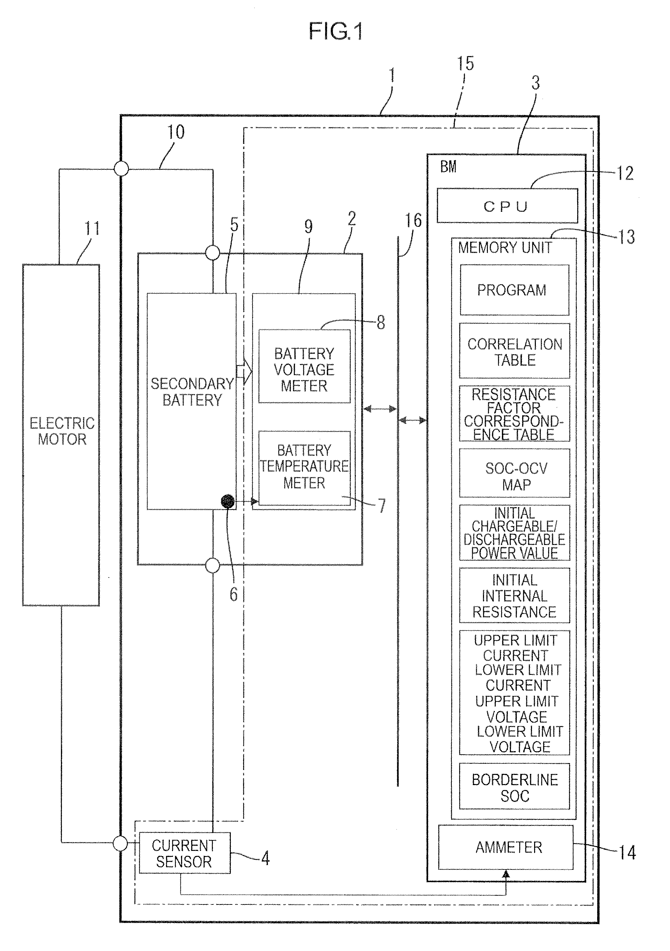

A battery pack 1 according to an embodiment will be described with reference to FIGS. 1 to 11. The battery pack 1 is an example of an electric storage apparatus. The battery pack 1 is installed in an electric vehicle or a hybrid vehicle (hereinafter referred to as a vehicle) and controlled by an electric control unit (hereinafter referred to as the ECU), which is not illustrated. With the control by the ECU, the battery pack 1 supplies power to an electrically-powered device that operates with electrical energy or receives power from the electrically powered device.

When a driver presses the gas pedal of the vehicle, for example, the battery pack 1 starts discharging. The ECU converts electric energy to motion energy and drives an electric motor 11 (drive motor). When the driver presses the brake pedal, the ECU controls the electric motor 11 to operate as an electrical generator to convert motion energy to electric energy. With this configuration, the electric motor 11 can charge a secondary battery 5 with regeneration brake. The ECU controls the electric motor 11 to start charging the battery pack 1 with power at a chargeable power level or slightly lower than the chargeable power level.

As illustrated in FIG. 1, the battery pack 1 includes a battery module 2, a battery manager (hereinafter referred to as the BM) 3, and a current sensor 4. The BM 3 manages the battery module 2. The battery module 2 includes a secondary battery 5, a temperature sensor 6, a battery temperature meter 7, and a battery voltage meter 8. The battery temperature meter 7 and the battery voltage meter 8 are arranged on a common circuit board, which will be referred to as a cell sensor (hereinafter referred to as the CS) 9. The BM 3 and the CS 9 are examples of a processing unit and a power estimation device.

The secondary battery 5 is an example of an electric storage device. The secondary battery 5 may be a lithium ion battery or may be a capacitor. The secondary battery 5 and the current sensor 4 are connected to the electric motor 11 in series via electric lines 10. The temperature sensor 6 is arranged in contact with or adjacent to the secondary battery 5. The battery temperature meter 7 may be a contact-type or a non-contact type temperature meter 7 configure to measure a temperature D (°C) of the secondary battery 5 using the temperature sensor 6 and to send a measurement result to the BM 3 via a communication line 16. The battery voltage meter 8 measures a terminal voltage V (V) of the secondary battery 5 and sends a measurement result to the BM 3 via the communication line 16.

The BM 3 includes a central processing unit (hereinafter referred to as the CPU) 12, a memory unit 13, and an ammeter 14. The ammeter 14 measures a current value I (A) of a charge current that flows from the electric motor 11 to the secondary battery 5 or a discharge current that flow from the secondary battery 5 to the electric motor 11 (hereinafter referred to as a charge/discharge current) using the current sensor 4. A configuration including the BM 3, the current sensor 4, and the CS9 is referred to as a battery management system (hereinafter referred to as the BMS) 15. The BMS 15 is examples of a processing unit and a power estimation device. The memory unit 13 is an example of a memory unit.

The memory unit 13 stores various programs for controlling operation of the CS 9. The CPU 12 executes control processes for various sections of the battery pack 1 such as a chargeable/dischargeable power estimation process, which will be described later, according to programs read out of the memory unit 13. The memory unit 13 stores an initial open circuit voltage E0, an initial chargeable power value WC0, an initial dischargeable power value WD0, an initial internal resistance R0 of the secondary battery 5, and a resistance factor correspondence table. The memory unit 13 also stores a borderline SOC, which will be described later. The initial chargeable power value WC0 and the initial dischargeable power value WD0 are examples of reference power values. The initial internal resistance R0 is an example of a reference resistance. The initial open circuit voltage E0 is an example of a reference open circuit voltage.

Resistance factors are factors indicating ratios of resistances to an initial resistance R0 of the secondary battery 5. The resistance factors vary according to the temperatures and SOCs of the secondary battery 5. The resistance factor correspondence table contains the resistance factors related to combinations of temperatures and SOCs of the secondary battery 5. The memory unit 13 stores an SOC-OCV map that represents relationships between the SOCs and open circuit voltages (herein after referred to as the OCVs). The memory unit 13 also stores an upper limit voltage Vm, a lower limit voltage Vs, an upper limit current Im, and an upper limit current Is of the second battery 5, which will be described later The upper limit voltage Vm and the lower limit voltage Vs are examples of a limit voltage. The upper limit current Im and the lower limit current Is are examples of a limit current.

Current Limit Condition and Voltage Limit Condition of Secondary Battery During Charge

The secondary battery 5 enters a current limit condition or a voltage limit condition depending on the present SOC. The current limit condition is a condition in which a current that flows through the secondary battery 5 needs to be limited because the current that flows through the secondary battery 5 reaches the upper limit current Im before a terminal voltage thereof reaches the upper limit voltage Vm. The voltage limit condition is a condition in which the terminal voltage of the secondary battery 5 needs to be limited because the terminal voltage of the secondary battery 5 reaches the upper limit voltage Vm before the current that flows therethrough reaches the upper limit current Im.

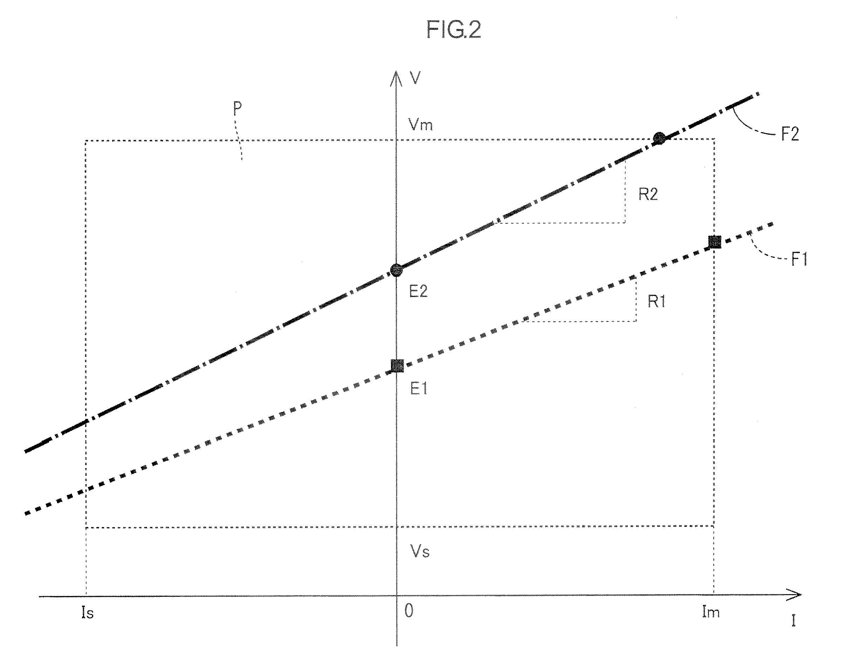

As illustrated in FIG. 2, the upper limit current Im and the upper limit voltage Vm are upper limits of an operable range P of the secondary battery 5. The operable range P is a rated operable range in which the secondary battery 5 is safely operable. The upper limit current Im and the upper limit voltage Vm may be upper limits of a predefined control range of the ECU. The lower limit voltage Vs and the lower limit current Is are indicated in FIG. 2 as lower limits of the operable range P.

A straight line F1 in FIG. 2 represents variation characteristics of the secondary battery 5 that is in the current limit condition relative to the charge/discharge current. The OCV of the secondary battery 5 is a first voltage E1 and the internal resistance thereof is a first resistance R1. According to the straight line F1, the current that flows through the secondary battery 5 reaches the upper limit current Im before the terminal voltage thereof reaches the upper limit voltage Vm. Therefore, the secondary battery 5 having the characteristics represented by the straight line F1 is determined as in the current limit condition.

A straight line F2 in FIG. 2 represents variation characteristics of the secondary battery 5 that is in the voltage limit condition relative to the charge/discharge current. The OCV of the secondary battery 5 is a second voltage value E2 (> E1) and the internal resistance thereof is a second resistance value R2 (> R1). According to the straight line F2, the terminal voltage of the secondary battery 5 reaches the upper limit voltage Vm before the current that flows therethrough reaches the upper limit current Im. Therefore, the secondary battery 5 having the characteristics represented by the straight lime F2 is determined as in the voltage limit condition.

As is clear from FIG. 2, whether the secondary battery 5 is in the current limit condition or the voltage limit condition depends mainly on the OCV and the internal resistance of the secondary battery 5. Especially, if a variation in temperature of the secondary battery 5 is small and a variation in internal resistance is small, whether the secondary battery 5 is in the current limit condition or the voltage limit condition depends mainly on the OCV of the secondary battery 5. The open circuit voltage of the secondary battery 5 has a correlation with the SOC and the internal resistance thereof has a correlation with a deterioration level of the secondary battery 5.

Current Limit Condition and Voltage Limit Condition of Secondary Battery During Discharge

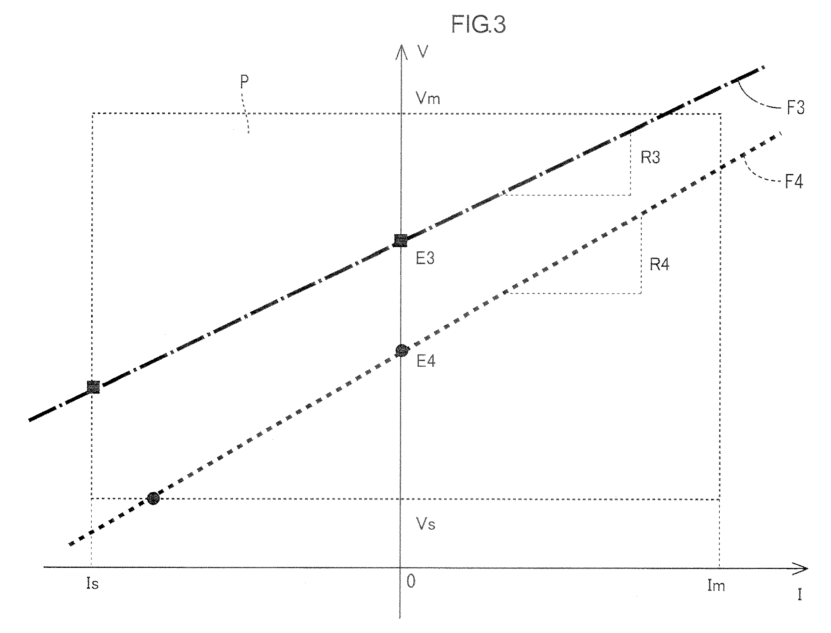

As illustrated in FIG. 3, the lower limit current Is and the lower limit voltage Vs are lower limits of the operable range P of the secondary battery 5. The lower limit current Is and the lower limit voltage Vs may be lower limits of a predefined control range of the ECU.

A straight line F3 in FIG. 3 represents variation characteristics of the terminal voltage of the secondary battery 5 that is in the current limit condition relative to the charge/discharge current. The OCV of the secondary battery 5 is a third voltage E3 and the internal resistance thereof is a third resistance R3. According to the straight line F3, the current that flows through the secondary battery 5 reaches the lower limit current Is before the terminal voltage thereof reaches the lower limit voltage Vs. Therefore, the secondary battery 5 having the characteristics represented by the straight line F3 is determined as in the current limit condition.

A straight line F4 in FIG. 3 represents variation characteristics of the terminal voltage of the secondary battery 5 that is in the voltage limit condition relative to the charge/discharge current. The OCV of the secondary battery 5 is a fourth voltage E4 (< E3) and the internal resistance thereof is a fourth resistance value R4 (< R3). According to the straight line F4, the terminal voltage of the secondary battery 5 reaches the lower limit voltage Vs before the current flowing therethrough reaches the lower limit current Is. Therefore, the secondary battery 5 having the characteristics represented by the straight line F4 is determined as in the voltage limit condition.

Chargeable Power Estimation Process

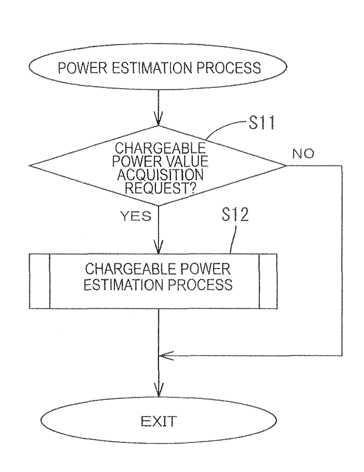

When power is supplied by the secondary battery 5, for example, the BMS 15 executes a power estimation process illustrated in FIG. 4. Specifically, the CPU 12 determines whether a chargeable power value acquisition request from the ECU to the CPU 12 for acquiring a chargeable power value is received (S11). The chargeable power value acquisition request may be reception of an external signal from the ECU or other device by the CPU 12. Examples of the external signal include a signal requesting a start of charge and a brake signal.

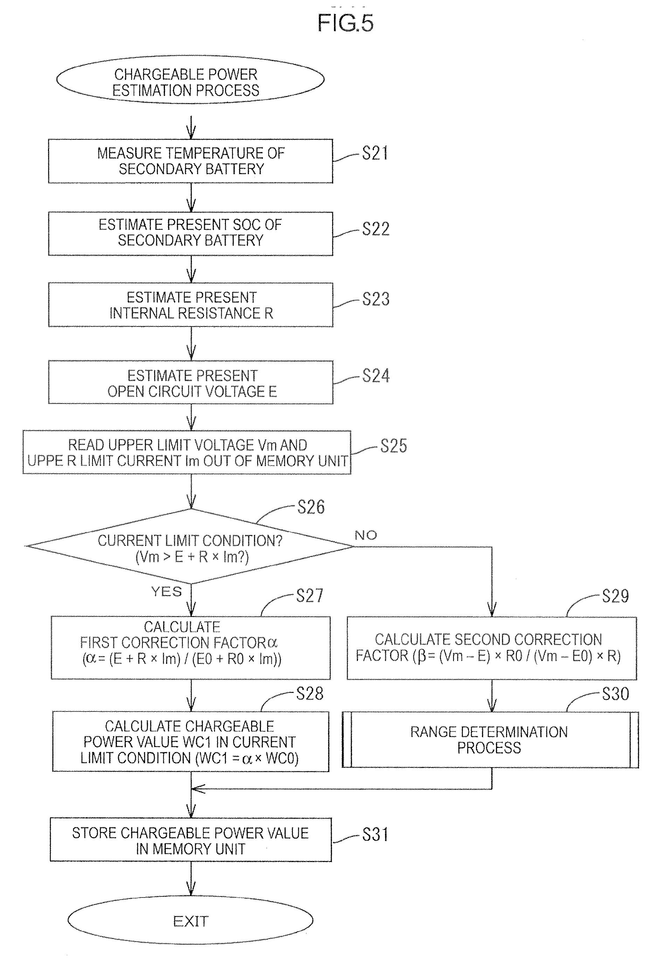

If the chargeable power value acquisition request is not received (NO in step S11), the CPU 12 does not execute a chargeable power estimation process. If the chargeable power value acquisition request is received (YES in step S11), the CPU 12 executes the chargeable power estimation process illustrated in FIG. 5 (S12).

If the chargeable power value acquisition request from the ECU is received (YES in step S11), the CPU 12 determines whether the present condition of the secondary battery 5 is the current limit condition or the voltage limit condition (S26) as illustrated in FIG. 5. As described earlier, whether the condition of the secondary battery 5 is the current limit condition or the voltage limit condition depends mainly on the internal resistance and the OCV of the secondary battery 5. Therefore, the CPU 12 estimates the present internal resistance R and the present OCV of the secondary battery 5. Step S26 is an example of a condition determination process.

Specifically, the CPU 12 detects the present temperature of the secondary battery 5 based on a measurement provided by the battery temperature meter 7 (S21) and estimates the present SOC of the secondary battery (S22).

The CPU 12 estimates the present SOC as follows. The CPU 12 detects the open circuit voltage of the secondary battery 5 based on a measurement provided by the battery voltage meter 8 in a condition that the secondary battery 5 is not in used for several hours while the vehicle is parked. The CPU 12 refers the SOC-OCV map stored in the memory unit 13, and defines the SOC corresponding to the detected OCV as an initial SOC. If the driver turns on an ignition key, for example, the CPU 12 starts accumulating charge/discharge currents of the secondary battery 5 with time. The CPU 12 uses results of measurements performed by the ammeter 14.

The CPU 12 adds an SOC corresponding to the accumulated charge/discharge current at present to the initial SOC and defines the result of the addition as the present SOC. Various known technologies may be used to estimate an SOC. The CPU 12 may be configured to execute steps S21 and S22 at the same time or to execute step S22 first and then to execute step S21.

The CPU 12 estimates the present internal resistance R of the secondary battery 5 based on the temperature and the present SOC of the secondary battery 5 (S23). The CPU 12 refers to the internal resistance factor correspondence table stored in the memory unit 13 and reads out a resistance factor corresponding to the temperature of the secondary battery 5 obtained in step S21 and the present SOC obtained in step S22. The CPU 12 estimates the present internal resistance R based on a value calculated by multiplying the initial internal resistance R0 stored in the memory unit 13 by the factor read out of the memory unit 13.

The estimation of the present internal resistance R of the secondary battery 5 is also for estimating a deterioration level of internal resistance R of the secondary battery 5. Various known technologies may be used to estimate the present internal resistance R of the secondary battery 5. Step S23 is an example of an internal resistance estimation process.

The CPU 12 refers to the SOC-OCV map and estimates the present open circuit voltage E of the secondary battery 5 corresponding to the present SOC obtained in step S22 (S24). Step S24 is an example of an open circuit voltage estimation process. The estimation of the present open circuit voltage E of the secondary battery 5 is also for estimating the present SOC of the secondary battery 5. The CPU 12 may be configured to execute step S23 and step 24 at the same time or to execute step S24 first and then to execute step S23. Various known technologies may be used to estimate the present open circuit voltage E.

The CPU 12 reads the initial chargeable power WC0, the initial internal resistance R0, the initial open circuit voltage E0, the upper limit voltage Vm, and the upper limit current Im of the secondary battery 5 out of the memory unit 13 (S25). The initial internal resistance R0 is an internal resistance of the secondary battery 5 in an initial condition relative to the present temperature and the present SOC.

The CPU 12 determines whether the present condition of the secondary battery 5 is the current limit condition or the voltage limit condition (S26). Specifically, the CPU 12 estimates a terminal voltage V (= E + R × Im) of the secondary battery 5 with an assumption that a current that flows through the secondary battery 5 is equal to the upper limit current Im. The CPU 12 estimates the terminal voltage V based on the upper limit current Im, the present internal resistance R, and the present open circuit voltage E. This estimation step is an example of a terminal voltage estimation process.

If the terminal voltage V is lower than the upper limit voltage Vm (YES in step S26), the CPU 12 determines that the condition of the secondary battery 5 is the current limit condition. The CPU 12 reads the initial chargeable power value WC0, the initial internal resistance R0, and the initial open circuit voltage E0 of the secondary battery 5 out of the memory unit 13. The CPU 12 calculates a first correction factor $\alpha$ by Equation 1 (S27) and a chargeable power value WC1 by Equation 2 (S28). The CPU 12 stores the chargeable power value WC1 in the memory unit 13 (S31) and returns to the power estimation process illustrated in FIG. 4.

$$\alpha = (E + R \times Im) / (E0 + R0 \times Im) \qquad (1)$$

$$WC1 = \alpha \times WC0 \qquad (2)$$

Step S28 is an example of a first power estimation process. The initial internal resistance R0 and the upper limit current Im are examples of reference voltage information and "R0 × Im" is an example of a reference voltage.

The CPU 12 may be configured to assign 1 to $\alpha$ (i.e., $\alpha$ = 1) in the Equation 2 if $\alpha$ is larger than 1.

If the terminal voltage V is equal to or higher than the upper limit voltage Vm (NO in step S26), the CPU 12 determines that the condition of the secondary battery 5 is the voltage limit condition. The CPU 12 reads the initial chargeable power WC0, the initial internal resistance R0, and the initial open circuit voltage E0 of the secondary battery 5 out of the memory unit 13. The CPU 12 calculates a second correction factor by Equation 3 (S29), and then executes a range determination process (S30), which will be described later.

$$\beta = (Vm - E) \times R0 / (Vm - E0) \times R \qquad (3)$$

The initial internal resistance R0 and the voltage upper limit Vm are examples of reference current information and "Vm / R0" is an example of a reference current.

If it is assumed that the secondary battery 5 is not much deteriorated, the CPU 12 determines that the initial open circuit voltage E0 and the present open circuit voltage E of the secondary battery 5 are equal. The CPU 12 may be configured to calculate $\beta$ by Equation 4 instead of Equation 3 if the initial open circuit voltage E0 and the present open circuit voltage E of the secondary battery 5 are equal.

$$\beta = R0 / R \qquad (4)$$

The CPU 12 may be configured to calculate β by Equation 3 or 4.

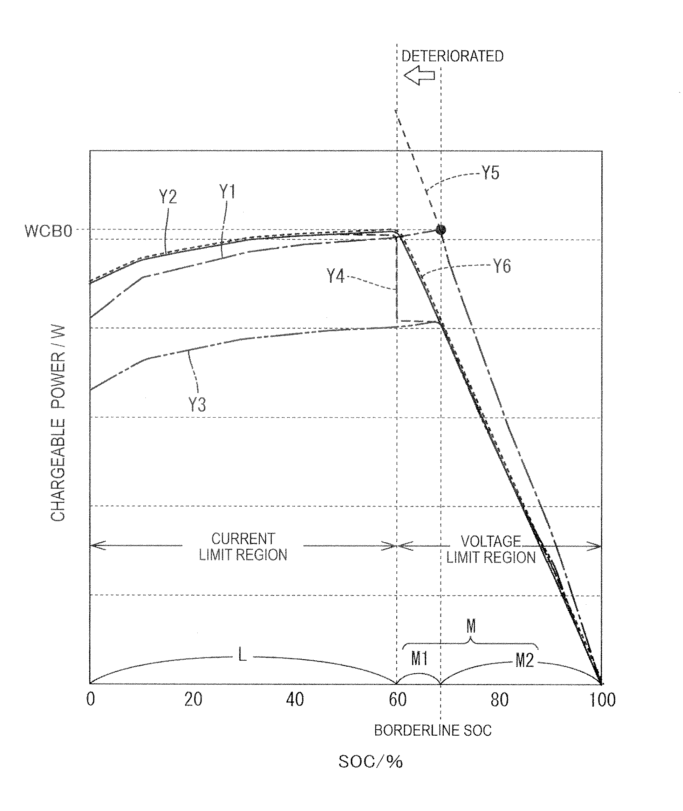

Each curve in FIG. 6 represents a relationship between the chargeable power and the SOC of the secondary battery 5 with the internal resistance thereof at a specific value. The SOC is expressed in percentage. A variation range of the SOC is from 0% to 100%. The 0% SOC indicates that the secondary battery 5 is fully discharged and the 100% SOC indicates that the secondary battery 5 is fully charged.

The curve Y1 in FIG. 6 represents the relationship between chargeable power and SOC of the secondary battery 5 that is in the initial condition. In a portion of the curve Y1 having a positive gradient, the condition of the secondary battery 5 is the current limit condition. A region of the graph in which the curve Y1 has a positive gradient is hereinafter referred to as a current limit region. In a portion of curve Y1 having a negative gradient, the condition of the secondary battery 5 is the voltage limit condition. A region of the graph in which the curve Y1 has a negative gradient is hereinafter referred to as a voltage limit region. The current limit region and the voltage limit region are affected by different factors, which are current and voltage. Therefore, the curve Y1 representing the relationship between the chargeable power and the SOC is bent at a point.

The curve Y2 in FIG. 6 represents the relationship between chargeable power and SOC of the secondary battery 5 that is in a deteriorated condition. In general, an internal resistance increases when a secondary battery is deteriorated and a voltage of the secondary battery tends easily to reach an upper limit voltage. As a result, a voltage limit region expands. As illustrated in FIG. 6, the SOC range of the curve Y2 has a range L in which the chargeable power increases and a range M in which the chargeable power decreases. The range L and the range M correspond to the current limit region and the voltage limit region of the secondary battery 5 in the deteriorated condition, respectively. The range M includes a section M1 and a section M2. When the curve Y2 is compared with the curve Y1, the section M1 corresponds to the current limit region of the secondary battery 5 in the initial condition but to the voltage limit region of the secondary battery 5 in the deteriorated condition. The section M2 corresponds to the voltage limit regions of the secondary battery 5 in the initial condition and the deteriorated condition. Namely, the voltage limit region of the secondary battery 5 in the deteriorated condition expands in comparison to the voltage limit region of the secondary battery 5 in the initial condition.

As illustrated in FIG. 6, the range M corresponds to the voltage limit region of the secondary battery 5 in the deteriorated condition and is a range in which the chargeable power of the secondary battery 5 after being deteriorated decreases for almost the entire range. Therefore, in the range M, to estimate the chargeable power of the secondary battery 5 in the deteriorated condition, the CPU 12 needs to multiply the chargeable power of the secondary battery 5 in the initial condition by a factor such that the chargeable power of the secondary battery 5 after being deteriorated is lower than the initial chargeable power. Such a factor is specifically a value smaller than 1. Meanwhile, the range L corresponds to the current limit region of the secondary battery 5 in the deteriorated condition and is a range in which the chargeable power of the secondary battery after being deteriorated increases. Therefore, in the range L, that is, when the secondary battery 5 in the deteriorated condition is in the current limit region, to estimate the chargeable power thereof, the CPU 12 needs to multiply the chargeable power of the secondary battery 5 in the initial condition by a factor such that the chargeable power of the secondary battery 5 after being deteriorated is higher than the initial chargeable power. Such a factor is specifically a value larger than 1.

Namely, in estimation of the chargeable power of the secondary battery 5, the CPU 12 uses different factors in the range L and the range M. If the CPU 12 uses the same factor as the one that is used in the range M in the range L, the chargeable power varies as illustrated by a curve Y3. The CPU 12 estimates the power lower than an actual power level in the range L. Therefore, the ECU cannot make the maximum use of the charging performance of the secondary battery 5.

If the CPU 12 utilizes a factor defined in the section M2 in the section M1, the chargeable power sharply decreases in the section M1 as illustrated by a curve Y4. A reason for that is as the follows. The section M1 corresponds to the current limit region of the secondary battery 5 in the initial condition but the correspondence changes due to the deterioration of the secondary battery 5, that is, the section M1 corresponds to the voltage limit region of the secondary battery 5 in the deteriorated condition. The CPU 12 determines that the secondary battery 5 is in the voltage limit region and multiplies the initial chargeable power by a factor such that the chargeable power of the secondary battery 5 after being deteriorated decreases.

If the chargeable power sharply decreases, drivability of the vehicle for the driver may be impaired. If the chargeable power sharply decreases, the EPU limits the charge of the secondary battery 5. The ECU switches brake control from one that uses a regeneration brake to one that uses a pad brake. Because the feeling of braking changes, the drivability for the driver is impaired.

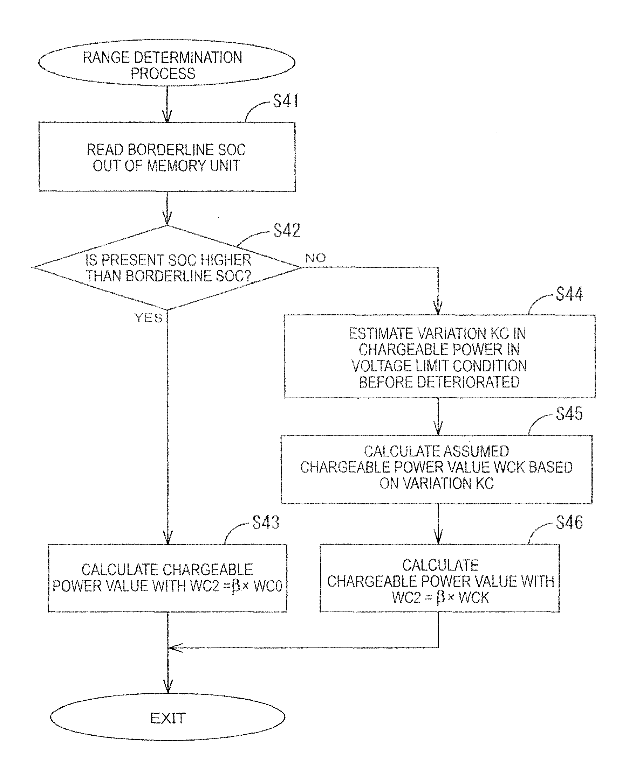

To resolve such a sharp change in chargeable power, the CPU 12 executes a range determination process illustrated in FIG. 7 (step S30 in FIG. 5).

Range Determination Process During Charge

The range determination process is a process for determining whether the present SOC of the secondary battery 5 is in the section M1 or the section M2 performed by the CPU 12. In this process, the CPU 12 estimates the chargeable power based on a result of the determination on whether the present SOC is in the section M1 or the section M2. The chargeable power is different in each range. The CPU 12 reads a borderline SOC out of the memory unit 13 (S41). The borderline SOC is an SOC at a borderline between the range L and the range M.

The CPU 12 compares the present SOC of the secondary battery 5 with the borderline SOC (S42). If the present SOC is higher than the borderline SOC (YES in step S42), that is, the present SOC is within the section M2, the CPU 12 calculates the chargeable power value WC2 with Equation 5 (S43). Then, the CPU 12 terminates the range determination process and returns to the chargeable power estimation process illustrated in FIG. 5. Step S43 is an example of a second power estimation process.

$$WC2 = \beta \times WC0 \qquad (5)$$

If the present SOC is equal to or lower than the borderline SOC (NO in step S42), that is, the present SOC is within the section M1, the CPU 12 estimates a variation KC (= $\Delta W / \Delta SOC$) based on the borderline SOC, an initial chargeable power value WCBO at the borderline SOC, and the condition of the secondary battery 5 at full charge (S44). The condition of the secondary battery 5 at full charge refers to a chargeable power (0W) and an SOC (100%) of the secondary battery 5 at full charge. The borderline SOC is an example of a boundary condition.

Specifically, the CPU 12 estimates the variation KC in chargeable power as follows. The CPU 12 estimates the variation KC in chargeable power by dividing a result of subtraction of the chargeable power of the secondary battery 5 at full charge from the initial chargeable power value WCBO at the borderline SOC by a result of subtraction of the SOC of the secondary battery 5 at full charge from the borderline SOC.

The CPU 12 calculates an assumed chargeable power value WCK of the secondary battery 5 at the present SOC (S45). As illustrated by a curve Y5 in FIG. 6, the assumed chargeable power value is a chargeable power value calculated by the CPU 12 based on assumption that the SOC has a proportional relationship with the chargeable power in the voltage limit region. Specifically, the CPU 12 calculates the assumed chargeable power value WCK of the secondary battery 5 at the present SOC with Equation 6.

$$WCK = KC \times (\text{present SOC}) - KC \times (\text{borderline SOC}) + WCB0 \qquad (6)$$

The CPU 12 calculates the chargeable power value WC2 with Equation 7 (S46). With this configuration, as illustrated with the curve Y6 in FIG. 6, an occurrence of sharp drop in chargeable power can be reduced. Step S46 is an example of the second power estimation process.

$$WC2 = \beta \times WCK \qquad (7)$$

The CPU 12 terminates the range determination process and returns to step S30 in FIG. 5. The CPU 12 stores the chargeable power value WC2 in the memory unit 13 and terminates the chargeable power estimation process. The CPU 12 returns to the power estimation process illustrated in FIG. 4.

Dischargeable Power Estimation Process

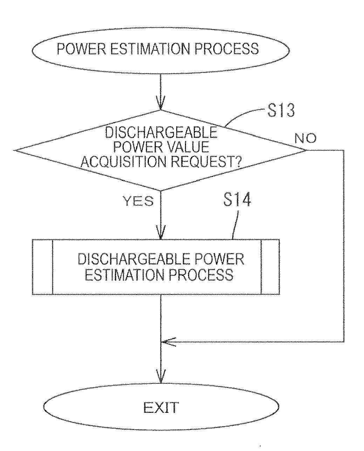

The BMS 15 starts a power estimation process illustrated in FIG. 8 when power is supplied by the secondary battery 5, for example. Specifically, the CPU 12 determines whether a dischargeable power value acquisition request from the ECU to the CPU 12 for acquiring the dischargeable power value is received (S13). An example of the reception of the request is reception of an external signal, such as a discharge activation signal from the ECU or an acceleration signal, by the CPU 12.

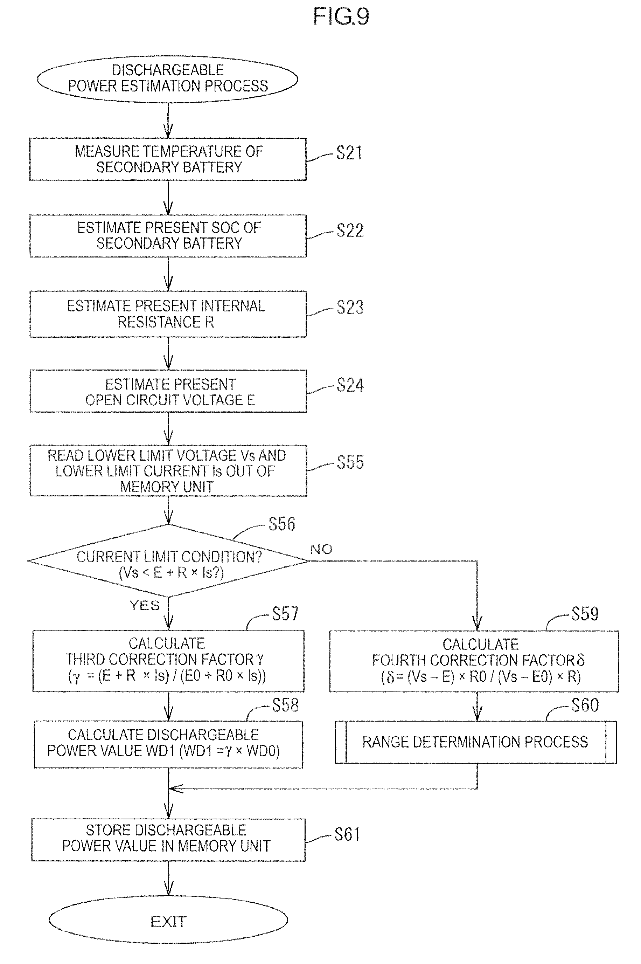

If the dischargeable power value acquisition request is not received (NO in step S13), the CPU 12 does not execute a dischargeable power estimation process. If the request is received (YES in step S13), the CPU 12 executes the dischargeable power estimation process illustrated in FIG. 9 (S14).

If the CPU 12 determines that the dischargeable power value acquisition request is sent from the ECU to the CPU 12 (YES in step S13), the CPU 12 determines whether the present condition of the secondary battery 5 is the current limit condition or the voltage limit condition (S56) as illustrated in FIG. 9.

The CPU 12 reads the lower limit voltage Vs and the lower limit current Is of the secondary battery 5 out of the memory unit 13 (S55). The CPU 12 executes a condition determination process to determine whether the present condition of the secondary battery 5 is the current limit condition or the voltage limit condition (S56). Step S56 is an example of a condition determination process.

Specifically, the CPU 12 estimates the terminal voltage V (= E + R × Is) with an assumption that a value of the current that flows through the secondary battery 5 is equal to the lower limit current Is. The CPU 12 estimates the terminal voltage based on the lower limit current Is, the present internal resistance R, and the present open circuit voltage E. This estimation process is an example of a terminal voltage calculation process.

If the terminal voltage V is lower than the lower limit voltage Vs, that is, the condition of the secondary battery 5 is the current limit condition (YES in step S56), the CPU 12 reads the initial dischargeable power value WD0, initial internal resistance R0, and initial open circuit voltage E0 of the secondary battery 5 out of the memory unit 13. The CPU 12 calculates a third correction factor γ with Equation 8 (S57) and a dischargeable power value WD1 with Equation 9 (S58). The CPU 12 stores the dischargeable power value WD1 in the memory unit 13 (S61) and returns to step S14 in FIG. 8.

$$\gamma = (E + R \times Is) / (E0 + R0 \times Is) \qquad (8)$$

$$WD1 = \gamma \times WD0 \qquad (9)$$

Step S58 is an example of the first power estimation process. The initial internal resistance R0 and the current lower limit Is are an example of reference voltage information. "R0 × Is" is an example of a reference voltage.

If the terminal voltage V is equal to or lower than the lower limit voltage Vs, that is, the condition of the secondary battery is the voltage limit condition (NO in step S56), the CPU 12 reads the initial dischargeable power value WD0, the initial internal resistance R0, and the initial open circuit voltage E0 of the secondary battery 5 out of the memory unit 13. The CPU 12 calculates the fourth correction factor δ with Equation 10 (S59) and executes a range determination process (S60), which will be described later.

$$\delta = (Vs - E) \times R0 / (Vs - E0) \times R \qquad (10)$$

The initial internal resistance R0 and the voltage lower limit Vs are an example of reference current information. "Vs / R0" is an example of a reference current value.

For example, if it is assumed that the secondary battery 5 has not been severely deteriorated, the CPU 12 can assume that the present open circuit voltage E of the secondary battery 5 is equal to the initial open circuit voltage E0. In this case, the CPU 12 may calculate the fourth correction factor δ with Equation 11 instead of Equation 10.

$$\delta = R0 / R \qquad (11)$$

Namely, the CPU 12 can calculate the fourth correction factor δ with Equation 10 or 11.

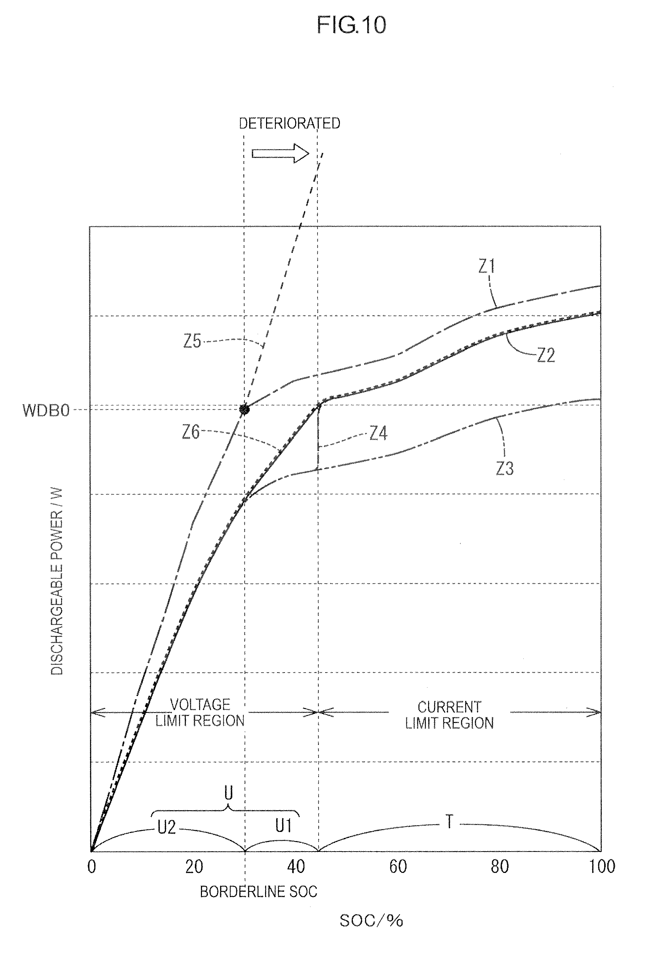

Curves that represent relationships between dischargeable power and SOC of the secondary battery 5 with specific internal resistances are illustrated in FIG. 10. SOCs are expressed in percentage and a variation range thereof is from 0% to 100%. The 0% SOC represents that the secondary battery 5 is fully discharged and the 100% SOC represents that the secondary battery 5 is fully charged.

The curve Z1 in FIG. 10 represents a relationship between dischargeable power of the secondary battery 5 that is in the initial condition and SOC. In a portion of the curve Z1 having a relatively gentle positive gradient, the condition of the secondary battery 5 is the current limit condition. A region of the graph in which the Z1 has the relatively gentle positive gradient is hereinafter referred to as the current limit region. In a portion of the curve Z1 having a relatively steep positive gradient, the condition of the secondary battery 5 is the voltage limit condition. A region of the graph in which the curve Z1 has the relatively steep positive gradient is hereinafter referred to as the voltage limit region. The current limit region and the voltage limit region are affected by different factors, which are current and voltage. Therefore, the curve Z1 representing the relationship between dischargeable power and SOC is bent at a point.

The curve Z2 in FIG. 10 represents a relationship between dischargeable power of the secondary battery 5 that is in the deteriorated condition and SOC. In general, an internal resistance increases when a secondary battery is deteriorated and a terminal voltage thereof tends easily to reach a voltage lower limit of the secondary battery. As a result, a voltage limit region expands. As illustrated in FIG. 10, the SOC range of the curve Z2 has a range U in which the curve Z2 has a relatively steep positive gradient and a range T in which the curve Z2 has a relatively gentle positive gradient. The range U and the range T correspond to the voltage limit region and the current limit region of the secondary battery 5 in the deteriorated condition, respectively. The range U includes a section U1 and a section U2. When the curve Z2 is compared with the curve Z1, the section U1 corresponds to the current limit region of the secondary battery 5 in the initial condition but to the voltage limit region of the secondary battery 5 in the deteriorated condition. The section U2 corresponds to the voltage limit regions of the secondary battery 5 in the initial condition and the deteriorated condition. Namely, the voltage limit region of the secondary battery 5 in the deteriorated condition expands in comparison to the voltage limit region of the secondary battery 5 in the initial condition.

As illustrated in FIG. 10, the range U corresponds to the voltage limit region when the secondary battery 5 is in the deteriorated condition. In this region, the dischargeable power of the secondary battery 5 after being deteriorated decreases as a whole. Therefore, the CPU 12 multiplies the initial dischargeable power by a factor such that the dischargeable power of the secondary battery 5 after being deteriorated decreases, specifically, a value smaller than 1. The range T corresponds to the current limit region when the secondary battery 5 is in the deteriorated condition. In this region, the dischargeable power of the secondary battery after being deteriorated decreases as a whole but a rate of decrease is smaller than a rate of decrease in the range U. Therefore, the CPU 12 multiplies the initial dischargeable power by a factor such that the dischargeable power of the secondary battery after being deteriorated decreases, specifically, a value smaller than 1 and larger than the value used in the range U.

To estimate the dischargeable power of the secondary battery 5, the CPU 12 uses different factors in the range U and the range T. If the factor used in the range U is also used in the range T, the dischargeable power varies as illustrated by a curve Z3. The CPU 12 estimates the power lower than necessary in the range T. Therefore, the ECU cannot make the maximum use of the discharging performance of the secondary battery 5.

If the CPU 12 utilizes a factor defined in the section U2 in the section U1, the dischargeable power sharply decreases in the section U1 as illustrated by a curve Z4. A reason for that is as the follows. The section U1 corresponds to the current limit region of the secondary battery 5 in the initial condition but the correspondence changes due to the deterioration of the secondary battery 5, that is, the section U1 corresponds to the voltage limit region of the secondary battery 5 in the deteriorated condition. The CPU 12 determines that the secondary battery 5 is in the voltage limit region and multiplies the initial dischargeable power by a factor such that the dischargeable power of the secondary battery 5 after being deteriorated decreases more than necessary.

If the dischargeable power sharply decreases, drivability of the vehicle for the driver may be impaired. If the dischargeable power sharply decreases, the ECU limits the discharge of the secondary battery 5. For example, the ECU limits an output of an engine of the vehicle. If the ECU limits the output of the engine, the vehicle does not accelerate even through the driver presses down the gas pedal. Because the feeling of driving changes, the drivability is impaired.

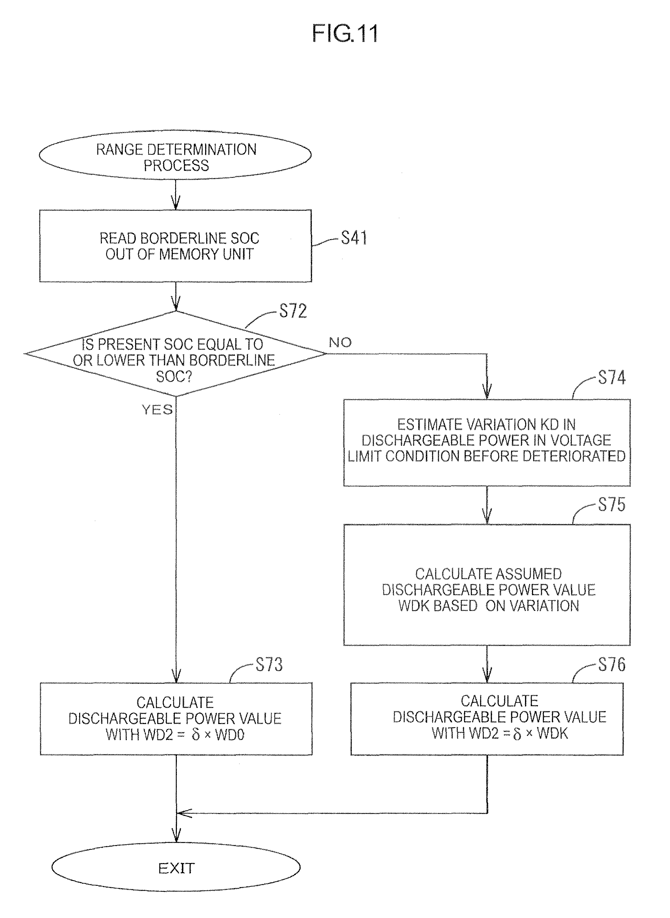

To resolve such a sharp change in dischargeable power, the CPU 12 executes a range determination process illustrated in FIG. 11 (step S60 in FIG. 9).

Range Determination Process During Discharge

The range determination process is a process for determining whether the present SOC of the secondary battery 5 is in the section U1 or the section U2 performed by the CPU 12. In this process, the CPU 12 estimates the dischargeable power based on a result of the determination on whether the present SOC is in the section U1 or the section U2. The dischargeable power differs from section to section.

The CPU 12 reads a borderline SOC out of the memory unit 13 (S41). The borderline SOC is an SOC at a borderline between the range U and the range T. The CPU 12 compares the present SOC of the secondary battery 5 with the borderline SOC (S72).

If the present SOC is equal to or lower than the borderline SOC (YES in step S72), that is, the present SOC is within the section U2, the CPU 12 calculates the dischargeable power value WD2 with Equation 12 (S73). Then, the CPU 12 terminates the range determination process and returns to the dischargeable power estimation process illustrated in FIG. 9. Step S73 is an example of a second power estimation process.

$$WD2 = \delta \times WD0 \qquad\qquad (12)$$

If the present SOC of the secondary battery 5 is higher than the borderline SOC (NO in step S72), that is, the present SOC is within the section U1, the CPU 12 estimates a variation KD (= $\Delta W$ / $\Delta SOC$) based on the borderline SOC, the initial dischargeable power value WDBO at the borderline SOC, and the condition of the secondary battery 5 that is at full discharge (S74). The condition of the secondary battery 5 at full discharge refers to a dischargeable power (0W) and an SOC (0%) of the secondary battery 5 at full discharge. Specifically, the CPU 12 estimates the variation KD in dischargeable power as follows. The CPU 12 estimates the variation in dischargeable power by dividing a result of subtraction of the dischargeable power of the secondary battery 5 at full discharge from the initial dischargeable power value WDBO at the borderline SOC by a result of subtraction of the SOC of the secondary battery 5 at full discharge from the borderline SOC.

The CPU 12 calculates an assumed dischargeable power value WDK of the secondary battery 5 with the present SOC (S75). The assumed dischargeable power is illustrated by a curve Z5 in FIG. 9. The assumed dischargeable power is a dischargeable power calculated by the CPU 12 based on assumption that the SOC has a proportional relationship with the dischargeable power. Specifically, the CPU 12 calculates the assumed dischargeable power value WDK of the secondary battery 5 with the present SOC with Equation 13.

$$WDK = KD \times (\text{Present SOC}) \qquad\qquad (13)$$

The CPU 12 calculates the dischargeable power value WD2 with Equation 14 (S76). With this configuration, as illustrated by the curve Z6 in FIG. 10, an occurrence of sharp drop in dischargeable power can be reduced. Step S76 is an example of the second power estimation process.

$$WD2 = \delta \times WDK \qquad\qquad (14)$$

The CPU 12 terminates the range determination process and returns to step S60 in FIG. 9. The CPU 12 stores the dischargeable power value WD2 in the memory unit 13 (S61) and terminates the dischargeable power estimation process. The CPU 12 returns to the power estimation process illustrated in FIG. 8.

Effects

According to this embodiment, the CPU 12 determines whether the condition of the secondary battery 5 is the current limit condition or the voltage limit condition at the time when the chargeable power value acquisition request, which is issued by the ECU, is received. If the condition of the secondary battery 5 is the current limit condition, the CPU 12 calculates the first correction factor $\alpha$ (= (E + R $\times$ Im) / (E0 + R0 $\times$ Im)) and the chargeable power value WC1 (= $\alpha$ $\times$ WC0). If the condition of the secondary battery 5 is the voltage limit condition, the CPU 12 calculates the second correction factor $\beta$ (= (Vm - E) $\times$ R0 / (Vm - E0) $\times$ R) and performs a determination on whether the present SOC of the secondary battery 5 is higher or lower than the borderline SOC. If the present SOC of the secondary battery 5 is higher than the borderline SOC, the CPU 12 calculates the chargeable power value WC2 (= $\beta$ $\times$ WC0). If the present SOC of the secondary battery 5 is equal to or lower than the borderline SOC, the CPU 12 calculates the assumed chargeable power value WCK (= KC $\times$ (Present SOC) - KC $\times$ (Borderline SOC) + WCBO) and the chargeable power value WC2 (= $\beta$ $\times$ WCK). With this configuration, the CPU 12 is less likely to inaccurately estimate the chargeable power due to the deterioration of the secondary battery 5.

According to this embodiment, the CPU 12 determines whether the condition of the secondary battery 5 is the current limit condition or the voltage limit condition at the time when the dischargeable power value acquisition request, which is issued by the ECU, is received. If the condition of the secondary battery 5 is the current limit condition, the CPU 12 calculates the third correction factor $\gamma$ (= (E + R $\times$ Is) / (E0 + R0 $\times$ Is)) and the dischargeable power value WD1 (= $\gamma$ $\times$ WD0). If the condition of the secondary battery 5 is the voltage limit condition, the CPU 12 calculates the fourth correction factor $\delta$ (= (Vs - E) $\times$ R0 / (Vs - E0) $\times$ R) and performs a determination on whether the present SOC of the secondary battery 5 is higher or lower than the borderline SOC. If the present SOC of the secondary battery 5 is equal to or lower than the borderline SOC, the CPU 12 calculates the dischargeable power value WD2 (= $\delta$ $\times$ WD0). If the present SOC of the secondary battery 5 is higher than the borderline SOC, the CPU 12 calculates the assumed dischargeable power value WDK (= KD $\times$ (Present SOC)) and the dischargeable power value WD2 (= $\delta \times$ WDK). With this configuration, the CPU 12 is less likely to inaccurately estimate the dischargeable power due to the deterioration of the secondary battery 5.

Other Embodiments

The present invention is not limited to the embodiment described above and illustrated in the drawings. The following various embodiments are also included in the technical scope of the present invention.

The CPU 12 may be configured to receive results of estimation or measurements (temperatures, SOCs and internal resistances) performed by external devices such as an ECU without executing at least one of steps S21 to S24 in FIG. 5 or FIG. 9. In this case, the CPU 12 does not require at least one of the battery temperature meter 7, the battery voltage meter 8, the current sensor 4, and the ammeter 14.

The CPU 12 may be configured to detect a direction of the current flowing through the electric lines 10 in step S11 in FIG. 4 or in step S13 in FIG. 8 based on a result of measurement performed by the current sensor 4. The CPU 12 may be configured to determine whether a chargeable power acquisition request is received or a dischargeable power acquisition request is received based on a condition that the detected direction is switched.

In the above embodiment, the reception of the external signal, such as a charge activation signal, an acceleration signal, or a brake signal from the ECU or other device, by the CPU 12 is provided as an example of a chargeable/dischargeable power value acquisition request. However, the chargeable/dischargeable power value acquisition request is not limited to such an example. The CPU 12 may be configured as follows. The CPU 12 may be configured to execute the chargeable/dischargeable power estimation process illustrated in FIG. 5 or FIG. 9, and then to execute the chargeable/dischargeable power estimation process again after a predetermined time has elapsed since the execution of the previous chargeable/dischargeable power estimation process. Namely, the CPU 12 may be configured to execute the chargeable/dischargeable power estimation process every predetermined time, that is, to periodically execute the chargeable/dischargeable power estimation process. The lapse of predetermined time may be considered as the chargeable/dischargeable power value acquisition request. A start of periodical execution of the chargeable/dischargeable power estimation process may be set to time at which an ignition key is turned on by the driver and power supply to the CPU 12 is started. The CPU 12 may be configured to execute the chargeable power estimation process and the dischargeable power estimation process every time the predetermined time passes or alternatively execute the chargeable power estimation process and the dischargeable power estimation process.

In the above embodiment, the CPU 12 estimates the internal resistance R of the secondary battery 5 based on the resistance factor correspondence table and the initial internal resistance. However, the estimation of the internal resistance R of the secondary battery 5 is not limited to such an example. The CPU 12 may be configured to measure a voltage of the secondary battery 5 using the battery voltage meter 8 and a current of the secondary battery 5 using the ammeter 14. The CPU 12 may be configured to calculate a straight line based on multiple pieces of data including the detected voltage and the detected current, and then to estimate the internal resistance R of the secondary battery 5 based on a gradient of the calculated straight line.

In the above embodiment, the CPU 12 calculates the SOC by adding the SOC corresponding to the present accumulated charge/discharge current to the initial SOC and defines the calculated SOC as an estimated SOC. The CPU 12 estimates the open circuit voltage E using the SOC-OCV map. However, the estimation of the open circuit voltage E is not limited to such an example. The CPU 12 may be configured to measure a voltage of the secondary battery 5 using the battery voltage meter 8 and a current of the secondary battery 5 using the ammeter 14. The CPU 12 may be configured to calculate a straight line based on multiple pieces of data including the detected voltage and the detected current. The CPU 12 may be configured to calculate the internal resistance R of the secondary battery 5 based on a gradient of the calculated straight line and then to estimate the open circuit voltage E by adding the detected voltage to a result of multiplication of the detected current by the internal resistance R.

In the above embodiment, the CPU 12 calculates the SOC by adding the SOC corresponding to the present accumulated charge/discharge current to the initial SOC and defines the calculated SOC as an estimated SOC. The CPU 12 estimates the open circuit voltage E using the SOC-OCV map. However, the estimation of the open circuit voltage E is not limited to such an example. The CPU 12 may be configured to measure a terminal voltage of the secondary battery 5 using the battery voltage meter 8 and a current that flows into the secondary battery 5 using the ammeter 14. The CPU 12 may be configured to calculate a straight line based on the estimated present internal resistance R and the measured voltage/current. The CPU 12 may be configured to estimate a voltage at which a current is zero according to the straight line as the present open circuit voltage E.

In the above embodiment, the CPU 12 defines the SOC calculated by adding the SOC corresponding to the present accumulated charge/discharge current to the initial SOC as the present SOC. However, the definition of the SOC is not limited to such an example. The CPU 12 may be configured to measure an OCV of the secondary battery 5 using the battery voltage meter 8, and then to define an SOC corresponding to the measured OCV as the present SOC with reference to the predefined SOC-OCV map.

In the above embodiment, during charge (or discharge), the CPU 12 determines whether the condition of the secondary battery 5 is the current limit condition or the voltage limit condition by comparing the terminal voltage V defined with the assumption that the current that flows through the secondary battery 5 is equal to the upper limit current Im (or the lower limit current Is) with the upper limit voltage Vm (or the lower limit voltage Vs) read out of the memory unit 13. However, the determination is not limited to such an example. The CPU 12 may be configured to determine whether the condition of the secondary battery 5 is the current limit condition or the voltage limit condition by estimating the current I that flows through the secondary battery 5 with the assumption that the terminal voltage of the secondary battery 5 is equal to the upper limit voltage Vm (or the lower limit voltage Vs) and by comparing the estimated current with the upper limit current Im (or the lower limit current Is) read out of the memory unit 13. Specifically, if the current I is larger than the upper limit current Im (or smaller than the lower limit current Is), the CPU 12 may determine that the condition of the secondary battery 6 is the current limit condition. If the current I is equal to or smaller than the upper limit current Im (or equal to or smaller than the lower limit current Is), the CPU 12 may determine that the condition of the secondary battery 6 is the voltage limit condition.

In the above embodiment, the drive motor is provided as an example of the electric motor 11. However, the electric motor 11 is not limited to the drive motor. For example, the electric motor 11 may be a charger for charging the secondary battery 5 from the outside of the vehicle, such as a plug-in station.

In the above embodiment, during charge (or discharge), the CPU 12 calculates the assumed chargeable/dischargeable power WCK (or WDK) and calculates WC2 (or WD2) if the initial condition of the secondary battery 5 having the present SOC is the current limit condition, that is, the present SOC of the secondary battery 5 is in the section M1 (or U1). However, the calculations are not limited to such examples. For example, the CPU 12 may be configured to determine whether the condition of the secondary battery 5 is the current limit condition or the voltage limit condition, and to calculate WC1 (or WD1) from "$\alpha \times$ WC0 ($\gamma \times$ WD0)" if the condition of the secondary battery 5 is the current limit condition. The CPU 12 may be configured to calculate WC2 (or WD2) from "$\beta \times$ WC0 ($\delta \times$ WD0)" if the condition of the secondary battery 5 is the voltage limit condition. Even with this configuration, the chargeable power (or the dischargeable power) is less likely to decrease more than necessary in comparison to the configuration in which the same factor is used for all initial chargeable power values WC0 (or all initial dischargeable power values WD0) in multiplication of the initial chargeable power value WC0 (or the initial dischargeable power value WD0) by the factor.

In the above embodiment, the memory unit 13 may store a table containing an initial chargeable power value and an initial dischargeable value for each SOC. The initial chargeable/dischargeable power may be chargeable/dischargeable power at a certain SOC when the internal resistance R of the secondary battery 5 is equal to the initial internal resistance R0. With this configuration, it is not necessary to store a table that contains initial chargeable/dischargeable power for each SOC in the memory unit 13. Therefore, unnecessarily large memory consumption can be reduced.

In the above embodiment, the CPU 12 executes the chargeable power estimation process or the dischargeable power estimation process (S12, S14), calculates the correction factor (S27, S29, S57, S59), and calculates the chargeable power (S28, S43, S46) or the dischargeable power (S58, S73, S76) based on the correction factor. However, the calculations are not limited to such examples. The CPU 12 may be configured to estimate the present internal resistance R of the secondary battery 5 (S23) and then to determine whether the present internal resistance R is higher than the initial internal resistance R0. The CPU 12 may be configured to calculate the correction factor and the chargeable/dischargeable power if the present internal resistance R is higher than the initial internal resistance R0.

**Claims**

1. A power estimation device for estimating at least one of chargeable power and dischargeable power of an electric storage device, the power estimation device comprising:

   a memory unit configured to store a reference power value; and
   a processing unit configured to perform:

   a condition determination process to determine whether a condition of the electric storage device is a voltage limit condition or a current limit condition;
   a first power estimation process to estimate at least one of chargeable power and dischargeable power of the electric storage device by multiplying the reference power value by a first correction factor if the condition of the electric storage device is the current limit condition; and
   a second power estimation process to estimate chargeable/dischargeable power by multiplying the reference power value by a second correction factor that is different from the first correction factor if the condition of the electric storage device is the voltage limit condition.

2. The power estimation device according to claim 1, wherein
the memory unit is configured to store reference voltage information related to a reference voltage that is a terminal voltage of the electric storage device when an internal resistance of the electric storage device is equal to a reference resistance and a current flowing through the electric storage device is equal to a limit current that is an upper limit current or a lower limit current, and reference current information related to a reference current that is a current flowing through the electric storage device when an internal resistance of the electric storage device is equal to the reference resistance and a terminal voltage of the electric storage device is equal to a limit voltage that is an upper limit voltage or a lower limit voltage, and
the processing unit is further configured to:

perform an internal resistance estimation process to estimate an internal resistance of the electric storage device;
estimate a terminal voltage of the electric storage device when a current flowing through the electric storage device is equal to the limit current based on the internal resistance estimated in the internal resistance estimation process and define a value calculated by dividing the estimated terminal voltage by the reference voltage as a first correction factor in the first power estimation process; and
estimate a current flowing through the electric storage device when a terminal voltage of the electric storage device is equal to the limit voltage based on the estimated internal resistance and define a value calculated by dividing the estimated current by the reference current as a second correction factor in the second power estimation process.

3. The power estimation device according to claim 1, wherein
the memory unit is configured to store reference voltage information and the reference current information include values corresponding to a reference open circuit voltage that is an open circuit voltage of the electric storage device when the internal resistance of the electric storage device is equal to the reference resistance,
the reference power value is a chargeable/dischargeable power value when the open circuit voltage of the electric storage device is equal to the reference open circuit voltage, and
the processing unit is further configured to:

perform an open circuit voltage estimation process to estimate an open circuit voltage of the electric storage device;
define a value calculated by dividing the estimated terminal voltage corresponding to the estimated open circuit voltage by the reference voltage as a first correction factor in the first power estimation process; and
define a value calculated by dividing the estimated current corresponding to the estimated open circuit voltage by the reference current as a second correction factor in the second estimation process.

4. The power estimation device according to claim 1, wherein
the memory unit is configured to store reference voltage information and reference current information,

the reference voltage information including a value corresponding to a reference voltage that is a terminal voltage of the electric storage device when an internal resistance of the electric storage device is equal to a reference resistance and a current flowing through the electric storage device is equal to a limit current that is an upper limit current or a lower limit current, and to a reference open circuit voltage that is an open circuit voltage of the electric storage device when the internal resistance of the electric storage device is equal to the reference resistance, and
the reference current information including a value corresponding to a reference current that is a current flowing through the electric storage device when an internal resistance of the electric storage device is equal to the reference resistance and a terminal voltage of the electric storage device is equal to a limit voltage that is an upper limit voltage or a lower limit voltage, and to the reference open circuit voltage,

the reference power value is a chargeable/dischargeable power value when the open circuit voltage of the electric storage device is equal to the reference open circuit voltage, and
the processing unit is configured to:

perform an open circuit voltage estimation process to estimate and open circuit voltage of the electric storage device;
perform an internal resistance estimation process to estimate an internal resistance of the electric storage device;
estimate a terminal voltage of the electric storage device when a current flowing through the electric storage device is equal to the limit current based on the internal resistance estimated in the internal resistance estimation process and define a value calculated by dividing the estimated terminal voltage by the reference voltage as a first correction factor in the first power estimation process; and

estimate a current flowing through the electric storage device when a terminal voltage of the electric storage device is equal to the limit voltage based on the estimated internal resistance and define a value calculated by dividing the estimated current by the reference current as a second correction factor in the second power estimation process.

5. The power estimation device according to any one of claims 1 to 4, wherein the processing unit is configured to estimate at least one of chargeable power and dischargeable power by multiplying a value larger than the reference power value by the second correction factor if the processing unit determines that the condition of the electric storage device is the voltage limit condition and a reference condition of the electric storage device corresponding to the reference power value is the current limit condition.

6. The power estimation device according to claim 5, wherein the processing unit is further configured to:

estimate a variation in chargeable/dischargeable power based on a boundary condition that is a condition of the electric storage device between the current limit condition and the voltage limit condition and the reference power value in the boundary condition;

estimate an assumed chargeable/dischargeable power value that is larger than the reference power value based on the variation, the boundary condition, and the reference power value in the boundary condition; and

estimate at least one of the chargeable power and the dischargeable power by multiplying the assumed chargeable/dischargeable power value by the second correction factor.

7. The power estimation device according to claim 1, wherein the processing unit is further configured to:

perform a terminal voltage estimation process to estimate a terminal voltage of the electric storage device when a current flowing through the electric storage device is equal to the upper limit current or the lower limit current; and

determine that the condition of the electric storage device is the voltage limit condition if the estimated terminal voltage is equal to or higher than the upper limit voltage or equal to or lower than the lower limit voltage and the condition thereof is the current limit condition if the estimated terminal voltage is lower than the upper limit voltage or higher than the lower limit voltage.

8. An electric storage apparatus comprising:

an electric storage device; and

the power estimation device according to any one of claims 1 to 7.

9. A method of estimating at least one of chargeable power and dischargeable power of an electric storage device, the method comprising:

determining whether a condition of the electric storage device is a voltage limit condition or a current limit condition;

estimating the chargeable/dischargeable power by multiplying the reference power value by a first correction factor if the condition of the electric storage device is the current limit condition; and

estimating the chargeable/dischargeable power by multiplying the reference power value by a second correction factor that is different from the first correction factor if the condition of the electric storage device is the voltage limit condition.

# FIG.1

# FIG.2

EP 2 720 055 A2

FIG.3

EP 2 720 055 A2

FIG. (flowchart)

POWER ESTIMATION PROCESS

S11

CHARGEABLE POWER VALUE ACQUISITION REQUEST?

NO

YES

S12

CHARGEABLE POWER ESTIMATION PROCESS

EXIT

# FIG.5

CHARGEABLE POWER
ESTIMATION PROCESS

MEASURE TEMPERATURE OF
SECONDARY BATTERY — S21

ESTIMATE PRESENT SOC OF
SECONDARY BATTERY — S22

ESTIMATE PRESENT
INTERNAL RESISTANCE R — S23

ESTIMATE PRESENT
OPEN CIRCUIT VOLTAGE E — S24

READ UPPER LIMIT VOLTAGE Vm AND
UPPE R LIMIT CURRENT Im OUT OF MEMORY UNIT — S25

S26

CURRENT LIMIT CONDITION?
$(Vm > E + R \times Im?)$

NO

YES

CALCULATE
FIRST CORRECTION FACTOR α
$(\alpha = (E + R \times Im) / (E0 + R0 \times Im))$ — S27

CALCULATE SECOND CORRECTION
FACTOR $(\beta = (Vm - E) \times R0 / (Vm - E0) \times R)$ — S29

CALCULATE CHARGEABLE
POWER VALUE WC1 IN CURRENT
LIMIT CONDITION $(WC1 = \alpha \times WC0)$ — S28

RANGE DETERMINATION
PROCESS — S30

STORE CHARGEABLE POWER VALUE
IN MEMORY UNIT — S31

EXIT

RANGE DETERMINATION
PROCESS

S41

READ BORDERLINE SOC
OUT OF MEMORY UNIT

S42

IS PRESENT SOC HIGHER
THAN BORDERLINE SOC?        NO

YES

S44

ESTIMATE VARIATION KC IN
CHARGEABLE POWER IN
VOLTAGE LIMIT CONDITION
BEFORE DETERIORATED

S45

CALCULATE ASSUMED
CHARGEABLE POWER VALUE WCK BASED
ON VARIATION KC

S43

CALCULATE CHARGEABLE
POWER VALUE WITH WC2 = $\beta \times$ WC0

S46

CALCULATE
CHARGEABLE POWER VALUE WITH
WC2 = $\beta \times$ WCK

EXIT

POWER ESTIMATION PROCESS

DISCHARGEABLE POWER VALUE ACQUISITION REQUEST? — S13

NO

YES

S14

DISCHARGEABLE POWER ESTIMATION PROCESS

EXIT

# FIG.9

DISCHARGEABLE
POWER ESTIMATION PROCESS

MEASURE TEMPERATURE OF
SECONDARY BATTERY — S21

ESTIMATE PRESENT SOC OF
SECONDARY BATTERY — S22

ESTIMATE PRESENT INTERNAL
RESISTANCE R — S23

ESTIMATE PRESENT
OPEN CIRCUIT VOLTAGE E — S24

READ LOWER LIMIT VOLTAGE Vs AND
LOWER LIMIT CURRENT Is OUT OF
MEMORY UNIT — S55

S56

CURRENT LIMIT CONDITION?
$(Vs < E + R \times Is?)$ — NO

YES

CALCULATE
THIRD CORRECTION FACTOR $\gamma$
$(\gamma = (E + R \times Is) / (E0 + R0 \times Is))$ — S57

CALCULATE
FOURTH CORRECTION FACTOR $\delta$
$(\delta = (Vs - E) \times R0 / (Vs - E0) \times R)$ — S59

CALCULATE DISCHARGEABLE
POWER VALUE WD1 $(WD1 = \gamma \times WD0)$ — S58

RANGE DETERMINATION PROCESS — S60

STORE DISCHARGEABLE
POWER VALUE IN MEMORY UNIT — S61

EXIT

# FIG.10

## FIG.11

RANGE DETERMINATION
PROCESS

READ BORDERLINE SOC
OUT OF MEMORY UNIT — S41

S72

IS PRESENT SOC EQUAL TO
OR LOWER THAN BORDERLINE
SOC?

NO

YES

ESTIMATE VARIATION KD IN
DISCHARGEABLE POWER IN VOLTAGE
LIMIT CONDITION BEFORE DETERIORATED — S74

CALCULATE ASSUMED
DISCHARGEABLE POWER VALUE
WDK BASED ON VARIATION — S75

CALCULATE
DISCHARGEABLE POWER VALUE
WITH $WD2 = \delta \times WD0$ — S73

CALCULATE
DISCHARGEABLE POWER VALUE
WITH $WD2 = \delta \times WDK$ — S76

EXIT

**EP 2 720 055 A2**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2007151216 A